# EUROPEAN PATENT APPLICATION

(11) **EP 4 844 759 A1**
(43) Date of publication of application: **25.11.2026**
(21) Application number: 26165661.5
(22) Date of filing: 18.03.2026
(51) Int. Cl.: G11C 5/02, G11C 11/412, H10B 10/00, H10B 10/10

(54) **INTEGRATED CIRCUIT INCLUDING MEMORY ENTITIES AND METHOD FOR DESIGNING SAME**

(30) Priority: 21.05.2025 KR 20250066409
(71) Applicant: Samsung Electronics Co., Ltd., Suwon-si, Gyeonggi-do 16677 (KR)
(72) Inventor: SUNG, Changhoon, 16677 Suwon-si, Gyeonggi-do (KR); KIM, Tae-Hyung, 16677 Suwon-si, Gyeonggi-do (KR); CHOI, Ji-Hyun, 16677 Suwon-si, Gyeonggi-do (KR); PARK, Young Rok, 16677 Suwon-si, Gyeonggi-do (KR)
(74) Representative: Kuhnen & Wacker Patent- und Rechtsanwaltsbüro PartG mbB

(57) **Abstract**

An integrated circuit including a plurality of memory entities (51, 52), each of which includes a memory cell array and a peripheral circuit, wherein the plurality of memory entities (51, 52) include a first memory entity (51) including first active patterns extending in a first direction (X) and first gate electrodes extending in a second direction (Y) intersecting with the first direction (X), and a second memory entity (52) adjacent the first memory entity (51) in the first direction (X) and including second active patterns extending in the first direction (X) and second gate electrodes extending in the second direction (Y), wherein a first tap structure (T53) extending in the second direction (Y) along a boundary (53) between the first memory entity (51) and the second memory entity (52) is shared by the first memory entity (51) and the second memory entity (52), and configured to bias a well (W3) or a substrate.

## Description

### BACKGROUND

### 1. Field

Example embodiments relate to an integrated circuit (IC), and more specifically, to an integrated circuit including memory entities, and a method for designing the same.

### 2. Description of the Related Art

A memory may store data, and may be used for processing a digital signal. An integrated circuit such as a system-on-chip (SoC) may include various memories embedded therein, and an area of the embedded memories may increase as an amount of data processing increases. Accordingly, an area of a memory may be significant in an integrated circuit.

Provided are an integrated circuit including a memory which may have a reduced area and a method for designing the same.

According to an aspect of the disclosure, there is provided an integrated circuit including a plurality of memory entities, each of the plurality of memory entities including a memory cell array and a peripheral circuit, wherein the plurality of memory entities includes: a first memory entity including first active patterns extending in a first direction and first gate electrodes extending in a second direction intersecting the first direction; and a second memory entity adjacent to the first memory entity in the first direction and including second active patterns extending in the first direction and second gate electrodes extending in the second direction, wherein a first tap structure extending in the second direction along a boundary between the first memory entity and the second memory entity is shared by the first memory entity and the second memory entity, and configured to bias a well or a substrate.

According to an aspect of the disclosure, there is provided an integrated circuit including a plurality of memory entities, each of the plurality of memory entities including a memory cell array and a peripheral circuit, wherein the plurality of memory entities includes: a first memory entity including first active patterns extending in a first direction and first gate electrodes extending in a second direction intersecting the first direction; and a second memory entity adjacent the first memory entity in the first direction and including second active patterns extending in the first direction and second gate electrodes extending in the second direction, wherein the first memory entity includes a first tap structure configured to bias a well or a substrate, and wherein the second memory entity includes a second tap structure configured to bias a well or a substrate, wherein the first gate electrodes have a first pitch, and a distance between the first tap structure and the second tap structure is less than two times the first pitch.

According to an aspect of the disclosure, there is provided an integrated circuit including a plurality of memory entities, each of the plurality of memory entities including a memory cell array and a peripheral circuit, wherein the plurality of memory entities includes: a first memory entity including first active patterns extending in a first direction and first gate electrodes extending in a second direction intersecting with the first direction; and a second memory entity adjacent the first memory entity in the first direction and including second active patterns extending in the first direction and second gate electrodes extending in the second direction, wherein an electrically floating active pattern extends in the first direction along a first boundary between the first memory entity and the second memory entity, and is shared by the first memory entity and the second memory entity.

### BRIEF DESCRIPTION OF DRAWINGS

The above and/or other aspects, features, and advantages of the present disclosure will become apparent and more readily appreciated from the following description of example embodiments, taken in conjunction with the accompanying drawings, in which:
FIG. 1A and FIG. 1B are drawings illustrating examples of an integrated circuit according to one or more embodiments;
FIG. 2 is a block diagram illustrating a memory entity according to one or more embodiments;
FIG. 3A, 3B, 3C, and FIG. 3D are drawings illustrating examples of an element according to one or more embodiments;
FIG. 4 is a drawing illustrating a layout of an integrated circuit according to one or more embodiments;
FIG. 5A and FIG. 5B are drawings illustrating examples of a layout of an integrated circuit according to one or more embodiments;
FIG. 6A, 6B, and FIG. 6C are drawings illustrating examples of a layout of an integrated circuit according to one or more embodiments;
FIG. 7A and FIG. 7B are drawings illustrating examples of a layout of an integrated circuit according to one or more embodiments;
FIG. 8 is a drawing illustrating a layout of an integrated circuit according to an one or more embodiment;
FIG. 9 is a drawing illustrating examples of a layout of an integrated circuit according to one or more embodiments;
FIG. 10A and FIG. 10B are drawings illustrating examples of a layout of an integrated circuit according to one or more embodiments;
FIG. 11A and FIG. 11B are drawings illustrating examples of a layout of an integrated circuit according to one or more embodiments;
FIG. 12 is a flowchart illustrating a method of manufacturing an integrated circuit according to one or more embodiments;
FIG. 13 is a drawing illustrating a method of designing an integrated circuit according to one or more embodiments;
FIG. 14 is a block diagram illustrating a system-on-chip (SoC) according to one or more embodiments; and
FIG. 15 is a block diagram illustrating a computing system including a memory storing a program according to one or more embodiments.

### DETAILED DESCRIPTION

All of the embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present.

As used herein, the term "and/or" includes any and all combinations of one or more of the associated listed items. As used herein, expressions such as "at least one of," when preceding a list of elements, modify the entire list of elements and do not modify the individual elements of the list. For example, the expression, "at least one of a, b and c," and "at least one of a, b, or c" should be understood as including only a, only b, only c, both a and b, both a and c, both b and c, or all of a, b and c.

It will be also understood that, even if a certain step or operation of manufacturing an apparatus or structure is described later than another step or operation, the step or operation may be performed later than the other step or operation unless the other step or operation is described as being performed after the step or operation.

Various embodiments of the present document and terms used therein are not intended to limit the technical features described in this document to specific embodiments, and should be understood to include various modifications, equivalents, or substitutes of the corresponding embodiments.

In connection with the description of the drawings, similar reference numerals may be used for similar or related components.

The singular form of a noun corresponding to an item may include one or a plurality of the items unless clearly indicated otherwise in a related context.

In addition, the terms "portion", "part", "unit", "module" or "member" may be implemented in hardware or software. Depending on the embodiments, a plurality of "portions", "parts", "units", "modules" or "members" may be implemented as a single element, or a single "portion", "part", "unit", "module" or "member" may include a plurality of elements.

It will be understood that, although the terms "first", "second", "third", "primary", "secondary", "tertiary", etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and/or" includes a plurality of combinations of relevant items or any one item among a plurality of relevant items.

When an element (e.g., a first element) is referred to as being "(functionally or communicatively) coupled" or "connected" to another element (e.g., a second element), the first element may be connected to the second element, directly (e.g., wired), wirelessly, or through a third element.

In this disclosure, the terms "containing", "including", "comprising", "having", and the like are used to specify features, numbers, steps, operations, elements, components, or combinations thereof, but do not preclude the presence or addition of one or more of the features, numbers, steps, operations, elements, components, or combinations thereof.

In addition, in the present disclosure, the meaning of "identical" includes cases where properties are similar to each other or similar within a certain range. Furthermore, unless clearly indicated, stated, and/or shown otherwise; as used herein the terms "identical", "uniform", "equal", and/or "the same" mean "substantially identical", "substantially uniform", "substantially equal", and/or "substantially the same". The meaning of substantially identical should be understood to include numerical values within manufacturing error ranges, machining or processing tolerances, and/or differences within a range that is so insignificant such that neither the structure nor function of the embodiments disclosed herein are materially altered, inhibited, or destroyed.

As used herein, the terms "front (or forward)", "rear (or back, rearward)", "left", "right", "up (or top)", "down (or bottom)" and the like may be defined with reference to the drawings, and may not be intended to limit the shape and position of each component.

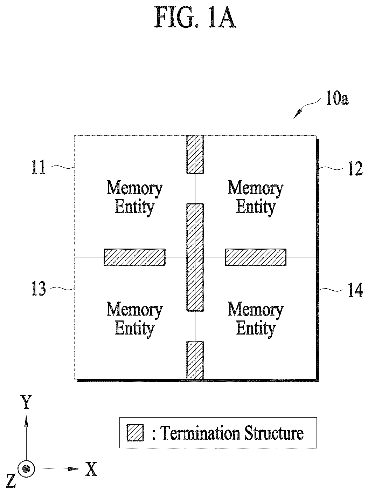

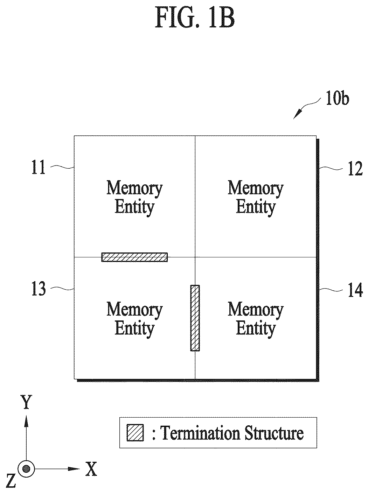

FIG. 1A and FIG. 1B are drawings illustrating examples of an integrated circuit (i.e., "IC", "semiconductor substrate", "chip", "die", etc.) according to one or more embodiments. For instance, FIG. 1A and FIG. 1B illustrate examples of an integrated circuit including a plurality of memory entities viewed from a plane including an X axis and a Y axis. In one or more embodiments, integrated circuits 10a and 10b of FIG. 1A and FIG. 1B may be manufactured by a semiconductor process. For instance, each of the integrated circuits 10a and 10b may be included in a die diced from a wafer which has passed through a semiconductor process, and may be packaged. Hereinafter, duplicate descriptions in descriptions with respect to FIG. 1A and FIG. 1B may be omitted.

Herein, a Y axis direction and an X axis direction may be respectively referred to as a first direction and a second direction, and a Z axis direction may be referred to as a third direction or a vertical direction. A plane constituted with the X axis and the Y axis may referred to as a horizontal plane, and a component disposed relatively in a +Z direction compared to another component may be referred to as being over the another component, and a component disposed relatively in a -Z direction compared to another component may be referred to as being below the another component. Further, an area of a component may refer to a size occupied by the component on a surface being in parallel with the horizontal surface, and a width of a component may refer to a length of a direction orthogonal to a direction in which the component extends. Further, in a case in which components are coupled or electrically connected, the corresponding components may be referred to as being connected. In the drawings herein, only some layers may be illustrated for the sake of convenience in illustration. Further, a pattern constituted with a conductive material such as a pattern of a routing layer may be referred to as a conductive pattern or simply as a pattern.

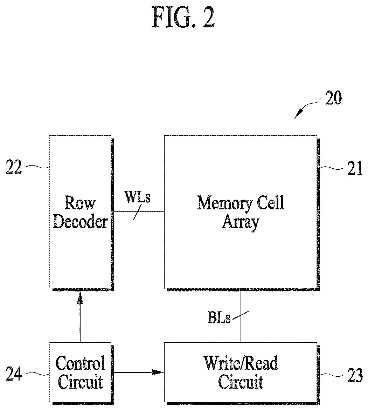

In one or more embodiments, an integrated circuit may include a plurality of memories and digital circuits accessing the plurality of memories. For instance, as illustrated in FIG. 1A, the integrated circuit 10a may include a first memory entity 11 to a fourth memory entity 14 which are adjacent to each other in the X axis direction or in the Y axis direction. A memory entity may include a memory cell array and a peripheral circuit, and may refer to a unit which may be operated as an independent memory device. Herein, the memory entity may be referred to as a memory macro. An example of the memory entity will be described hereinafter with reference to FIG. 2. The digital circuit may access the memory entity, and may write data into the memory entity or read the data stored in the memory entity out therefrom. For instance, the integrated circuit may include a programmable circuit such as a central processing unit (CPU), a graphic processing unit (GPU), a neural processing unit (NPU) and the like, may include a reconfigurable circuit such as a field programmable gate array (FPGA), and may include a circuit providing a fixed function such as an intellectual property (IP) block. The memory entity may be respectively included in the programmable circuit, the reconfigurable circuit and the circuit providing the fixed function.

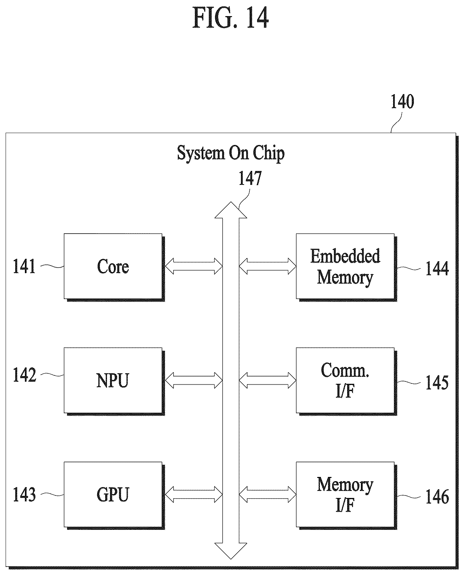

Like a system-on-chip (SoC) which is described below with reference to FIG. 14, various digital circuits may be included in the integrated circuit 10a, and accordingly, a plurality of memory entities, for instance, the first memory entity 11 to the fourth memory entity 14, may be included. For instance, in a case in which the integrated circuit 10a includes a processing core, the integrated circuit 10a may include memory entities corresponding to cache memories such as an L1 cache and an L2 cache.

In the integrated circuit 10a, each of the first memory entity 11 to the fourth memory entity 14 may include a termination structure. For instance, the first memory entity 11 may include the termination structure in order to have a designed structure and provide a designed performance even when another circuit, for instance, a memory entity or a digital circuit, is placed to be adjacent in the X axis direction or the Y axis direction. As illustrated in FIG. 1A, the first memory entity 11 and a second memory entity 12 may be adjacent to each other in the X axis direction, and termination structures may meet at a boundary between the first memory entity 11 and the second memory entity 12. Unless otherwise indicated, as used herein with regard to any of the respective memory entities, any two memory entities are considered "adjacent" or "adjacent to" one another so long as no other memory entity occupies a space between the two memory entities. That is, two memory entities are considered adjacent each other if the two memory entities are not separated from each other by an intervening memory entity. Further, the first memory entity 11 and a third memory entity 13 may be adjacent to each other in the Y axis direction, and the termination structures may meet at a boundary between the first memory entity 11 and the third memory entity 13.

Referring to FIG. 1B, the integrated circuit 10b may include the first memory entity 11 to the fourth memory entity 14 which are adjacent to each other in the X axis direction or in the Y axis direction. In the integrated circuit 10b, the termination structure may be omitted at a memory entity, or memory entities adjacent to each other may share the termination structure. For instance, as illustrated in FIG. 1B, the first memory entity 11 and the second memory entity 12 may be adjacent to each other in the X axis direction, and the termination structure may be omitted at the boundary between the first memory entity 11 and the second memory entity 12. Further, the second memory entity 12 and the fourth memory entity 14 may be adjacent to each other in the Y axis direction, and the termination structure may be omitted at a boundary between the second memory entity 12 and the fourth memory entity 14.

The first memory entity 11 and the third memory entity 13 may be adjacent to each other in the Y axis direction, and may share the termination structure extending in the X axis direction along the boundary between the first memory entity 11 and the third memory entity 13. Further, the third memory entity 13 and the fourth memory entity 14 may be adjacent to each other in the X axis direction, and may share the termination structure extending in the Y axis direction along a boundary between the third memory entity 13 and the fourth memory entity 14. Hereinafter, with reference to the drawings, examples in which a termination structure is omitted or shared in memory entities adjacent to each other will be described. With the termination structure being omitted or shared, an area of memory entities in an integrated circuit, in other words, an area of a memory, may be decreased, and an area of an integrated circuit may be decreased. That is, by omitting a termination structure, or sharing a termination structure among two or more respective memory entities, such that not every memory entity includes its own dedicated termination structure, a total area occupied by all of the memory entities combined may be decreased relative to an integrated circuit or SoC wherein each memory entity includes its own dedicated termination structure. Further, memory entities which are designed to be independent to each other may be easily placed, and accordingly, efficiency of an integrated circuit may be increased. FIG. 1B illustrates the integrated circuit 10b including four memory entities having an identical shape, but example embodiments are not limited thereto. For instance, the integrated circuit may include an arbitrary number of memory entities which are adjacent to each other, and may include memory entities having shapes different from each other, for instance, different sizes and/or different aspect ratios.

FIG. 2 is a block diagram illustrating a memory entity 20 according to one or more embodiments. As described above with reference to FIG. 1A and FIG. 1B, the integrated circuit may include a plurality of memory entities, and the memory entity 20 may be accessed in an independent manner from another memory entity. As illustrated in FIG. 2, the memory entity 20 may include a memory cell array 21, a row decoder 22, a write and read circuit 23 and a control circuit 24.

The memory cell array 21 may include memory cells. The memory cell may be a volatile memory cell such as a dynamic random access memory (DRAM) cell, a static random access memory (SRAM) cell and the like, and may be a non-volatile memory cell such as a flash memory cell, a resistive random access memory (RRAM) and the like. The memory cell may store 1 bit, and/or may store two or more bits, in other words, multiple bits. The memory cell may be connected to one of a plurality of word lines WLs, and may be connected to one of a plurality of bit lines BLs.

The row decoder 22 may be connected to the memory cell array 21 through the plurality of word lines WLs. The row decoder 22 may select one among the plurality of word lines WLs based on an address, and may activate a selected word line. Accordingly, the memory cells connected to the activated word line in the memory cell array 21 may be selected. In one or more embodiments, the row decoder 22 may receive a row address, and the memory entity 20 may further include a column decoder receiving a column address. The column decoder may select at least one of the plurality of bit lines BLs based on a column address. In one or more embodiments, the memory entity 20 may further include an address buffer which is connected to the row decoder 22 and stores an address received by the memory entity 20.

The write and read circuit 23 may be connected to the memory cell array 21 through the plurality of bit lines BLs. During a write operation, the write and read circuit 23 may apply a current and/or a voltage to at least one of the plurality of bit lines BLs and may write data into the memory cells selected by the row decoder 22. During a read operation, the write and read circuit 23 may detect a current and/or a voltage in at least one of the plurality of bit lines BLs and may read data stored in the memory cells selected by the row decoder 22 out therefrom. The memory entity 20 may further include an input and output buffer which is connected to the write and read circuit 23, and stores data received by the memory entity 20 to store the same in the memory cell array 21 or store data read out of the memory cell array 21.

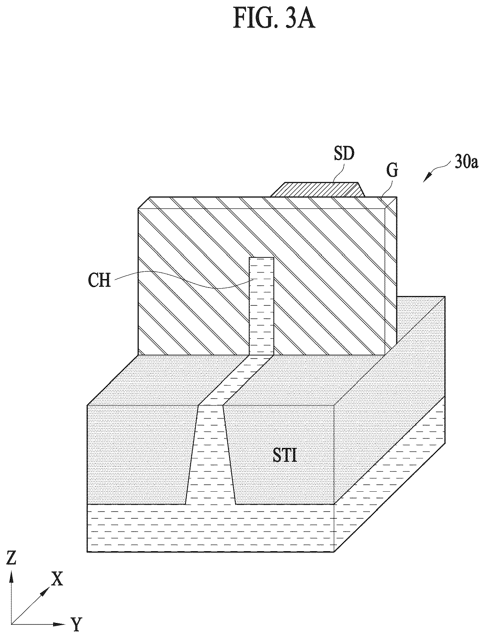

The control circuit 24 may decode a command received by the memory entity 20, and may control the row decoder 22 and the write and read circuit 23 based on the decoded command. For instance, the control circuit 24 may identify a write operation or a read operation based on a command, and may control the row decoder 22 and the write and read circuit 23 based on an identified operation. The memory cell array 21, the row decoder 22, the write and read circuit 23 and the control circuit 24 in FIG. 2 may include transistors, and examples of the transistor will be described with reference to FIG. 3A to FIG. 3D.

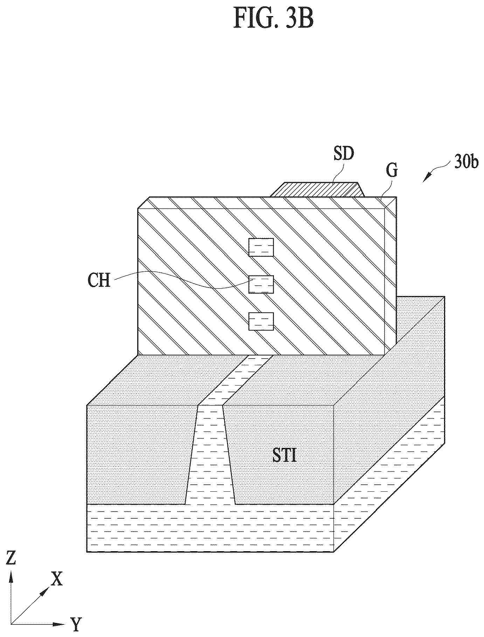

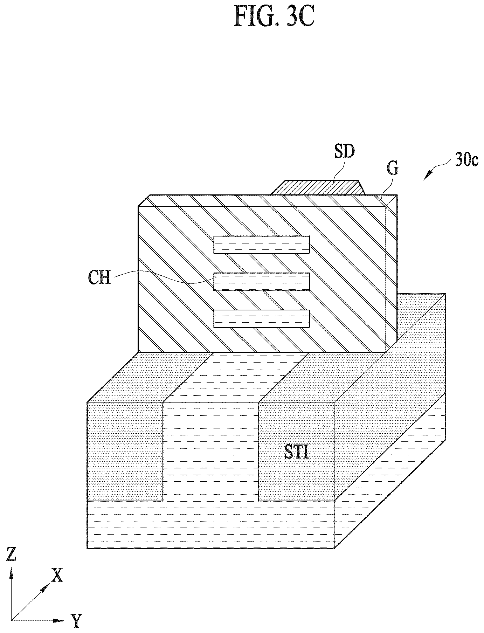

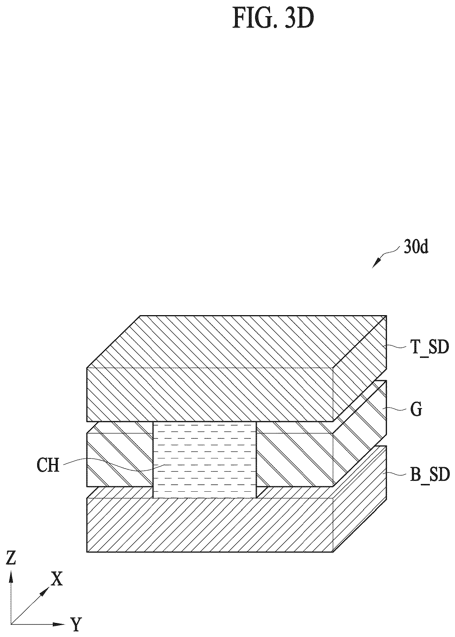

FIG. 3A to FIG. 3D are drawings illustrating examples of an element according to example embodiments. For instance, FIG. 3A indicates a FinFET 30a, and FIG. 3B indicates a gate-all-around field effect transistor (GAAFET) 30b, and FIG. 3C indicates a multi-bridge channel field effect transistor (MBCFET) 30c, and FIG. 3D indicates a vertical field effect transistor (VFET) 30d. For the sake of convenience in illustration, FIG. 3A to FIG. 3C illustrate one of two source/drain regions having been removed, and FIG. 3D indicates a cross section cutting the VFET 30d with a plane passing through a channel CH of the VFET 30d while being in parallel with a plane constituted with the Y axis and the Z axis.

Referring to FIG. 3A, the FinFET 30a may be formed by an active pattern in a fin shape extending in the X axis direction between shallow trench isolations (STI) and a gate G extending in the Y axis direction. The source/drain SD may be formed at both sides of the gate G, and accordingly, a source and a drain may be spaced apart from each other in the X axis direction. An insulation film may be formed between the channel CH and the gate G. In one or more embodiments, the FinFET 30a may be formed by the gate G and the plurality of active patterns spaced apart from each other in the Y axis direction.

Referring to FIG. 3B, the GAAFET 30b may be formed by active patterns which extend in the X axis direction by being spaced apart from each other in the Z axis direction, in other words, nanowires, and the gate G extending in the Y axis direction. The source/drain SD may be formed at both sides of the gate G, and accordingly, a source and a drain may be spaced apart from each other in the X axis direction. An insulation film may be formed between the channel CH and the gate G. It is noted that the number of the nanowires included in the GAAFET 30b is not limited to what is illustrated in FIG. 3B.

Referring to FIG. 3C, the MBCFET 30c may be formed by active patterns which extend in the X axis direction by being spaced apart from each other in the Z axis direction, in other words, nanosheets, and the gate G extending in the Y axis direction. The source/drain SD may be formed at both sides of the gate G, and accordingly, a source and a drain may be spaced apart from each other in the X axis direction. An insulation film may be formed between the channel CH and the gate G. It is noted that the number of the nanosheets included in the MBCFET 30c is not limited to what is illustrated in FIG. 3C.

Referring to FIG. 3D, the VFET 30d may include a top source/drain T_SD and a bottom source/drain B_SD which are spaced apart from each other in the Z axis direction with the channel CH placed therebetween. The VFET 30d may include the gate G surrounding a circumference of the channel CH between the top source/drain T_SD and the bottom source/drain B_SD. An insulation film may be formed between the channel CH and the gate G.

It is noted that elements included in an integrated circuit is not limited to examples of FIG. 3A to FIG. 3D. For instance, an integrated circuit may include a forksheet field-effect transistor (ForkFET) having a structure in which an N-type transistor and a P-type transistor are closer because nanosheets for the P-type transistor and nanosheets for the N-type transistor are separated by a dielectric wall. Further, the integrated circuit may include not only a FET such as a complementary field effect transistor (CFET), a negative capacitance field effect transistor (NCFET), a carbon nanotube (CNT) FET and the like but also a bipolar junction transistor.

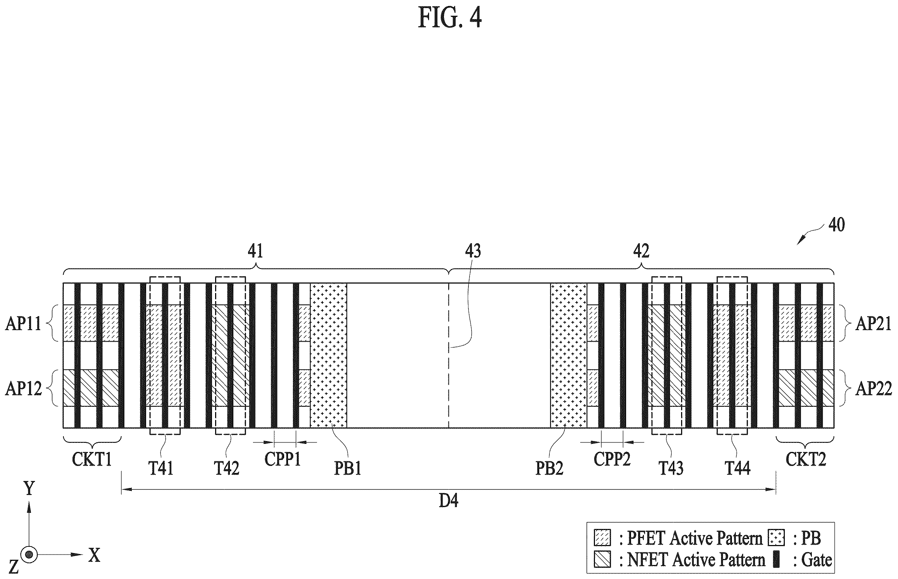

FIG. 4 is a drawing illustrating a layout of an integrated circuit 40 according to one or more embodiments. For instance, FIG. 4 illustrates a layout of the integrated circuit 40 including a first memory entity 41 and a second memory entity 42 which are adjacent to each other in the X axis direction. For the sake of convenience in illustration, FIG. 4 illustrates only a partial region of the first memory entity 41 and the second memory entity 42 around a boundary 43 between the first memory entity 41 and the second memory entity 42.

Referring to FIG. 4, in the integrated circuit 40, active patterns may extend in the X axis direction, and gates may extend in the Y axis direction. For instance, as illustrated in FIG. 4, the first memory entity 41 may include a first active pattern AP11 and a second active pattern AP12 extending in the X axis direction, and the second memory entity 42 may include a first active pattern AP21 and a second active pattern AP22 extending in the X axis direction. The first active patterns (e.g., AP11 and AP21) may form a p-channel field effect transistor (PFET) by intersecting with a gate electrode, and the second active patterns (e.g., AP12 and AP22) may form an n-channel field effect transistor (NFET) by intersecting with a gate electrode. In one or more embodiments, an active pattern may be removed at a partial region. For instance, as illustrated in FIG. 4, an active pattern may be removed between adjacent gates, such that the active pattern does not occupy a space between adjacent gates (i.e., the active pattern is not between adjacent gates). In one or more embodiments, different from what is illustrated in FIG. 4, gates adjacent to a region from which an active pattern is removed may be replaced with dummy gates. A pitch of gates, in other words, a distance between centers of gates adjacent to each other in the X axis direction may be referred to as a contacted poly pitch (CPP). As illustrated in FIG. 4, gates extending in the Y axis direction from the first memory entity 41 may have a first pitch CPP1, and gates extending in the Y axis direction from the second memory entity 42 may have a second pitch CPP2. In one or more embodiments, the first pitch CPP1 and the second pitch CPP2 may be identical.

As described above with reference to FIG. 1A, each of the first memory entity 41 and the second memory entity 42 may have a termination structure. For instance, as illustrated in FIG. 4, the first memory entity 41 may have a termination structure between a first circuit region CKT1 and the boundary 43. The first circuit region CKT1 may include a transistor included in a peripheral circuit or a memory cell array. The termination structure may include a first termination gate PB1, a first tap T41 and a second tap T42 which extend in the Y axis direction. A termination gate is a gate electrode having a wide width, and active patterns extending in the X axis direction may be terminated at the termination gate. A tap may be a structure disposed to bias a well or a substrate, and may be referred to as a tap structure herein. Further, an n-tap (or an n-tap structure) may refer to a tap biasing a well or a substrate with an n-type of a conductivity type, and a p-tap (or a p-tap structure) may refer to a tap biasing a well or a substrate with a p-type of a conductivity type. For instance, in a case in which a conductivity type of a substrate is a p-type, an n-tap may bias an n-well at a positive supply voltage, and a p-tap may bias a substrate at a negative supply voltage. In one or more embodiments, the first tap T41 of the first memory entity 41 may be a p-tap, and the second tap T42 may be an n-tap.

The second memory entity 42 may also include a termination structure between the boundary 43 and a second circuit region CKT2. The termination structure may include a second termination gate PB2, a third tap T43 and a fourth tap T44 which extend in the Y axis direction. In one or more embodiments, the third tap T43 of the second memory entity 42 may be an n-tap, and the fourth tap T44 may be a p-tap. As illustrated in FIG. 4, due to termination structures included in the first memory entity 41 and the second memory entity 42, the first circuit region CKT1 and the second circuit region CKT2 may be spaced apart by a distance D4, and an area for the termination structures may be required.

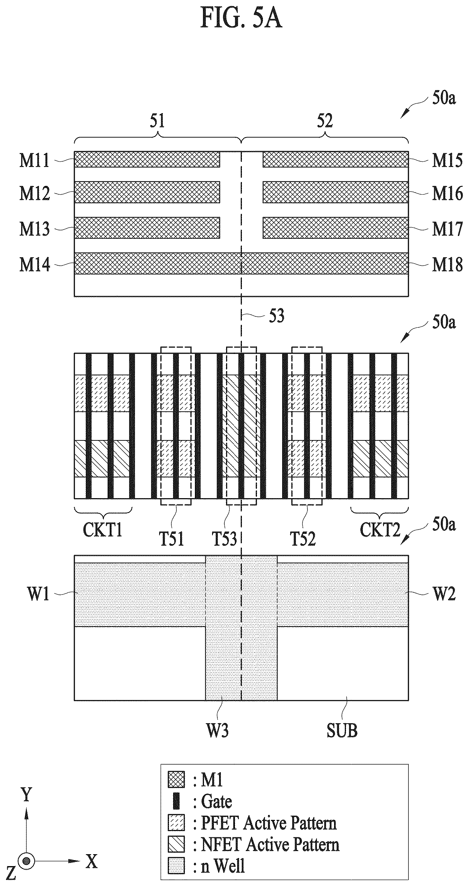

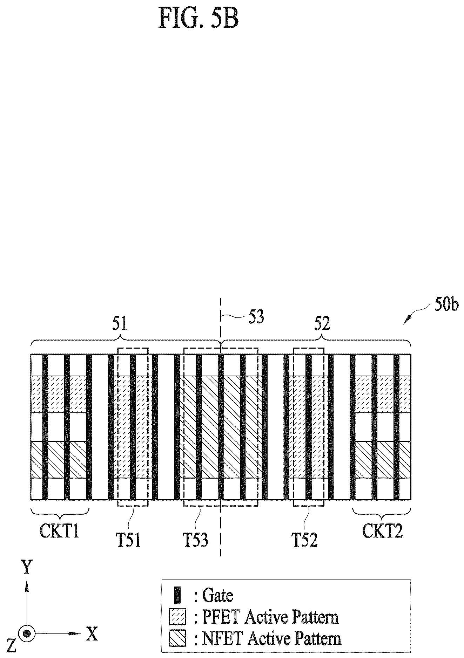

FIG. 5A and FIG. 5B are drawings illustrating examples of a layout of an integrated circuit according to example embodiments. For instance, FIG. 5A and FIG. 5B indicate layouts of integrated circuits 50a and 50b each including a first memory entity 51 and a second memory entity 52 which are adjacent to each other in the X axis direction. For the sake of convenience in illustration, FIG. 5A and FIG. 5B illustrate only a partial region of the first memory entity 51 and the second memory entity 52 around a boundary 53 between the first memory entity 51 and the second memory entity 52. Duplicate descriptions in descriptions with respect to FIG. 5A and FIG. 5B and duplicate descriptions to what is described above with reference to the drawings will be omitted.

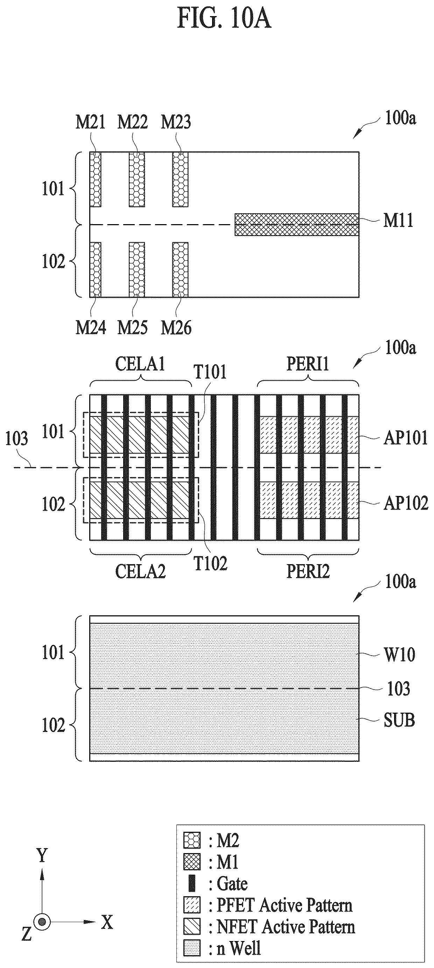

In FIG. 5A, layers of the integrated circuit 50a will be illustrated by being separated. A bottom drawing of FIG. 5A illustrates a substrate SUB and an n-well at the integrated circuit 50a, and a central drawing of FIG. 5A illustrates active patterns and gates in the integrated circuit 50a, and a top drawing of FIG. 5A illustrates a first routing layer M1 in the integrated circuit 50a. The first routing layer M1 is a routing layer closest to a transistor, and may be a metal layer, and additional routing layers may exist as a second routing layer M2 of FIG. 10A over the first routing layer M1.

Referring to the bottom drawing of FIG. 5A, the first memory entity 51 may include a first well W1 extending in the X axis direction in the substrate SUB, and the second memory entity 52 may include a second well W2 extending in the X axis direction in the substrate SUB. Further, the integrated circuit 50a may include a third well W3 extending in the Y axis direction along the boundary 53 in the substrate SUB, and the first memory entity 51 and the second memory entity 52 may share the third well W3. In other words, the first well W1 and the second well W2 may be connected to the third well W3.

Referring to the central drawing of FIG. 5A, the integrated circuit 50a may include active patterns extending in the X axis direction, and may include gates extending in the Y axis direction. The first memory entity 51 may include the first circuit region CKT1 and a first tap T51 extending in the Y axis direction. Further, the second memory entity 52 may include the second circuit region CKT2 and a second tap T52 extending in the Y axis direction. In one or more embodiments, the first circuit region CKT1 may include elements of a memory cell array of the first memory entity 51, and the second circuit region CKT2 may include elements of a memory cell array of the second memory entity 52. The integrated circuit 50a may include a third tap T53 extending in the Y axis direction along the boundary 53, and the first memory entity 51 and the second memory entity 52 may share the third tap T53. In one or more embodiments, the third tap T53 may be an n-tap, and the first tap T51 and the second tap T52 may be p-taps. Accordingly, the substrate SUB may be biased by the first tap T51 and the second tap T52, and the third well W3, and the first well W1 and the second well W2 connected to the third well W3, may be biased by the third tap T53.

Referring to the top drawing of FIG. 5A, the first memory entity 51 may include a first pattern M11 to a fourth pattern M14 which extend in the X axis direction in the first routing layer M1, and the second memory entity 52 may include a fifth pattern M15 to an eighth pattern M18 which extend in the X axis direction in the first routing layer M1. As illustrated in FIG. 5A, the first pattern M11 to a third pattern M13 and the fifth pattern M15 to a seventh pattern M17 may be terminated before having reached the boundary 53. In one or more embodiments, a supply voltage and/or signals of the first memory entity 51 may be applied to the first pattern M11 to a third pattern M13. For instance, each of the first pattern M11 to the third pattern M13 may correspond to a bit line or a complementary bit line, and may receive a positive supply voltage. Further, a supply voltage and/or signals of the second memory entity 52 may be applied to the fifth pattern M15 to the seventh pattern M17.

The fourth pattern M14 and the eighth pattern M18 may reach the boundary 53, and may be connected to each other at the boundary 53. In one or more embodiments, a supply voltage of the first memory entity 51 may be applied to the fourth pattern M14, and a supply voltage of the second memory entity 52 may be applied to the eighth pattern M18. For instance, a negative supply voltage (or a ground potential) of the first memory entity 51 and a negative supply voltage of the second memory entity 52 may be identical, and a negative supply voltage may be applied to the fourth pattern M14 and the eighth pattern M18. In the integrated circuit 50a of FIG. 5A, a first circuit CKT1 and a second circuit CKT2 may be closer than the distance D4 of FIG. 4, and accordingly, at the integrated circuit 50a, a region including the first memory entity 51 and the second memory entity 52 may have a decreased area.

Referring to FIG. 5B, the integrated circuit 50b may include active patterns extending in the X axis direction, and may include gates extending in the Y axis direction. The first memory entity 51 may include the first circuit region CKT1 and the first tap T51 extending in the Y axis direction. Further, the second memory entity 52 may include the second circuit region CKT2 and a second tap T52 extending in the Y axis direction. The integrated circuit 50b may include the third tap T53 extending in the Y axis direction along the boundary 53, and the first memory entity 51 and the second memory entity 52 may share the third tap T53. In one or more embodiments, the first circuit region CKT1 may include elements of a memory cell array of the first memory entity 51, and the second circuit region CKT2 may include elements of a memory cell array of the second memory entity 52. In one or more embodiments, the first tap T51 and the second tap T52 may be p-taps, and the third tap T53 may be an n-tap.

Compared to the integrated circuit 50a of FIG. 5A, the integrated circuit 50b may include the third tap T53 having an expanded width. For instance, the third tap T53 of FIG. 5A may include at least one gate and may have a width (in other words, a length in the X-axis direction) of 2 CPP or less, whereas the third tap T53 of FIG. 5B may include at least three gates and may have a width of 4 CPP or less. Accordingly, in the integrated circuit 50b, a distance between the first circuit region CKT1 and the second circuit region CKT2 may be longer than a distance between the first circuit region CKT1 and the second circuit region CKT2 in the integrated circuit 50a of FIG. 5A, whereas the third tap T53 of FIG. 5B may provide a stronger biasing than the third tap T53 of FIG. 5A. A width of a tap shared by memory entities adjacent to each other may be determined based on an area and biasing.

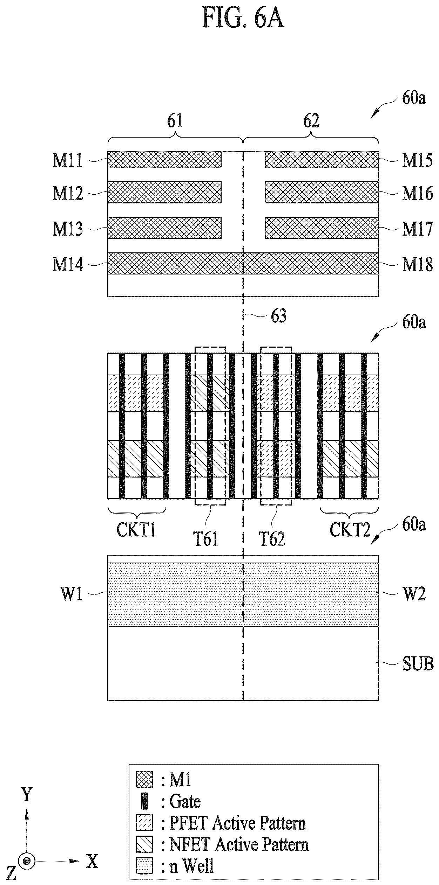

FIG. 6A to FIG. 6C are drawings illustrating examples of a layout of an integrated circuit according to example embodiments. For instance, FIG. 6A to FIG. 6C indicate layouts of integrated circuits 60a, 60b and 60c each including a first memory entity 61 and a second memory entity 62 which are adjacent to each other in the X axis direction. For the sake of convenience in illustration, FIG. 6A to FIG. 6C illustrate only a partial region of the first memory entity 61 and the second memory entity 62 around a boundary 63 between the first memory entity 61 and the second memory entity 62. Duplicate descriptions in descriptions with respect to FIG. 6A to FIG. 6C and duplicate descriptions to what is described above with reference to the drawings will be omitted.

In FIG. 6A, layers of the integrated circuit 60a will be illustrated by being separated. A bottom drawing of FIG. 6A illustrates the substrate SUB and an n-well at the integrated circuit 60a, and a central drawing of FIG. 6A illustrates active patterns and gates in the integrated circuit 60a, and a top drawing of FIG. 6A illustrates the first routing layer M1 in the integrated circuit 60a. The first routing layer M1 is a routing layer closest to a transistor, and may be a metal layer, and additional routing layers may exist over the first routing layer M1.

Referring to the bottom drawing of FIG. 6A, the first memory entity 61 may include the first well W1 extending in the X axis direction in the substrate SUB, and the second memory entity 62 may include the second well W2 extending in the X axis direction in the substrate SUB. The first well W1 and the second well W2 may reach the boundary 63, and may be connected to each other at the boundary 63. Accordingly, the first well W1 and the second well W2 may be connected to each other, and may correspond to a single well extending in the X axis direction across the boundary 63.

Referring to the central drawing of FIG. 6A, the integrated circuit 60a may include active patterns extending in the X axis direction, and may include gates extending in the Y axis direction. The first memory entity 61 may include the first circuit region CKT1 and a first tap T61 extending in the Y axis direction. Further, the second memory entity 62 may include the second circuit region CKT2 and a second tap T62 extending in the Y axis direction. In one or more embodiments, the first circuit region CKT1 may include elements of a memory cell array of the first memory entity 61, and the second circuit region CKT2 may include elements of a memory cell array of the second memory entity 62. In one or more embodiments, the first tap T61 and the second tap T62 may bias a well or the substrate SUB. For instance, the first tap T61 is an n-tap and may bias an n-well, in other words, the first well W1, and the second tap T62 is a p-tap, and may bias the substrate SUB. Accordingly, the second well W2 of the second memory entity 62 may be biased by the first tap T61, and at the first memory entity 61, a substrate may be biased by the second tap T62. Different from examples of FIG. 5A and FIG. 5B in which a tap extending along a boundary is shared, at the integrated circuit 60a of FIG. 6A, the first tap T61 of the first memory entity 61 and the second tap T62 of the second memory entity 62 may be adjacent to each other with the boundary 63 placed therebetween. In one or more embodiments, as illustrated in FIG. 6A, the first tap T61 and the second tap T62 may be closer than 2 CPP in the X axis direction. That is, a distance between the first tap T61 and the second tap T62 may be less than two times the first pitch CPP1

Referring to the top drawing of FIG. 6A, the first memory entity 61 may include the first pattern M11 to the fourth pattern M14 which extend in the X axis direction in the first routing layer M1, and the second memory entity 62 may include the fifth pattern M15 to the eighth pattern M18 which extend in the X axis direction in the first routing layer M1. As illustrated in FIG. 6A, the first pattern M11 to the third pattern M13 and the fifth pattern M15 to the seventh pattern M17 may be terminated before having reached the boundary 63. In one or more embodiments, a supply voltage and/or signals of the first memory entity 61 may be applied to the first pattern M11 to the third pattern M13. For instance, each of the first pattern M11 to the third pattern M13 may correspond to a bit line or a complementary bit line, and may receive a positive supply voltage. Further, a supply voltage and/or signals of the second memory entity 62 may be applied to the fifth pattern M15 to the seventh pattern M17.

The fourth pattern M14 and the eighth pattern M18 may reach the boundary 63, and may be connected to each other at the boundary 63. In one or more embodiments, a supply voltage of the first memory entity 61 may be applied to the fourth pattern M14, and a supply voltage of the second memory entity 62 may be applied to the eighth pattern M18. For instance, a negative supply voltage (or a ground potential) of the first memory entity 61 and a negative supply voltage of the second memory entity 62 may be identical, and a negative supply voltage may be applied to the fourth pattern M14 and the eighth pattern M18. Compared to the integrated circuit 40 of FIG. 4, the first circuit CKT1 and the second circuit CKT2 may be closer in the integrated circuit 60a of FIG. 6A, and accordingly, at the integrated circuit 60a, the first memory entity 61 and the second memory entity 62 may have a reduced area.

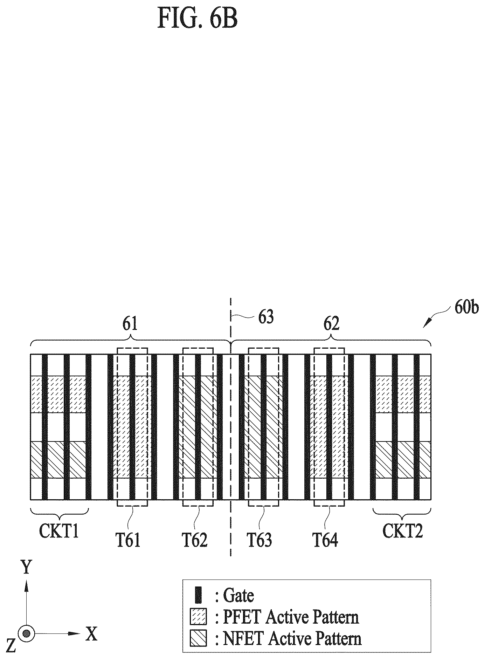

Referring to FIG. 6B, the integrated circuit 60b may include active patterns extending in the X axis direction, and may include gates extending in the Y axis direction. The first memory entity 61 may include the first circuit region CKT1 and may include the first tap T61 and the second tap T62 extending in the Y axis direction. Further, the second memory entity 62 may include the second circuit region CKT2 and may include a third tap T63 and a fourth tap T64 extending in the Y axis direction. In one or more embodiments, the first circuit region CKT1 may include elements of a memory cell array of the first memory entity 61, and the second circuit region CKT2 may include elements of a memory cell array of the second memory entity 62. In one or more embodiments, the first tap T61 and the fourth tap T64 may be p-taps, and the second tap T62 and the third tap T63 may be n-taps.

Compared to the integrated circuit 60a of FIG. 6A, in the integrated circuit 60b, each of the first memory entity 61 and the second memory entity 62 may further include an additional tap. Accordingly, in the integrated circuit 60b, a distance between the first circuit region CKT1 and the second circuit region CKT2 may be longer than a distance between the first circuit region CKT1 and the second circuit region CKT2 in the integrated circuit 60a of FIG. 6A, whereas a well and a substrate may be biased in a stronger manner in FIG. 6B due to added taps.

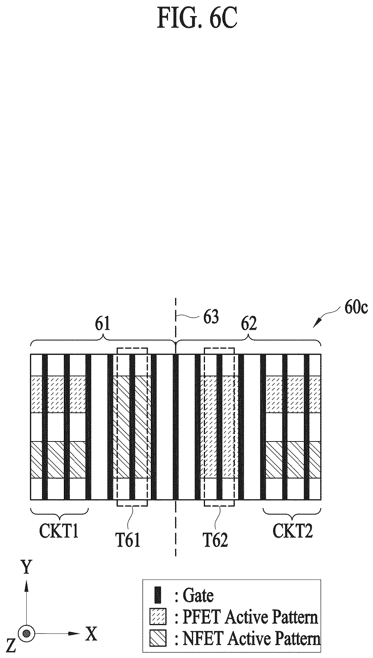

Referring to FIG. 6C, the integrated circuit 60c may include active patterns extending in the X axis direction, and may include gates extending in the Y axis direction. The first memory entity 61 may include the first circuit region CKT1 and may include the first tap T61 extending in the Y axis direction. Further, the second memory entity 62 may include the second circuit region CKT2 and may include the second tap T62 extending in the Y axis direction. In one or more embodiments, the first circuit region CKT1 may include elements of a memory cell array of the first memory entity 61, and the second circuit region CKT2 may include elements of a memory cell array of the second memory entity 62. In one or more embodiments, the first tap T61 may be an n-tap, and the second tap T62 may be a p-tap.

Compared to the integrated circuit 60a of FIG. 6A, in the integrated circuit 60c, the first tap T61 and the second tap T62 may be spaced farther apart in the X axis direction. For instance, in the integrated circuit 60a of FIG. 6A, the first tap T61 and the second tap T62 may be closer than 2 CPP, whereas, in FIG. 6C, the first tap T61 and the second tap T62 may be farther spaced apart than 2 CPP.

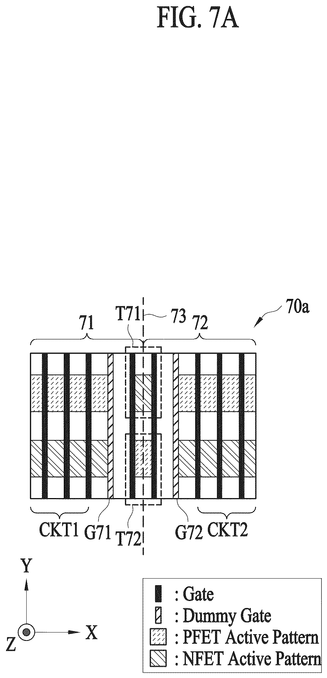

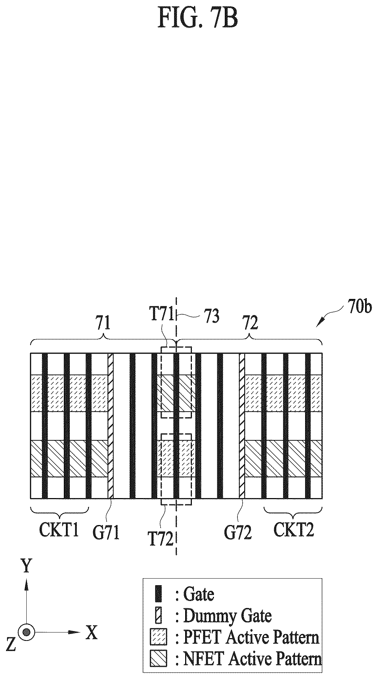

FIG. 7A and FIG. 7B are drawings illustrating examples of a layout of an integrated circuit according to example embodiments. For instance, FIG. 7A and FIG. 7B indicate layouts of integrated circuits 70a and 70b each including a first memory entity 71 and a second memory entity 72 which are adjacent to each other in the X axis direction. For the sake of convenience in illustration, FIG. 7A and FIG. 7B illustrate only a partial region of the first memory entity 71 and the second memory entity 72. Duplicate descriptions in descriptions with respect to FIG. 7A and FIG. 7B and duplicate descriptions to what is described above with reference to the drawings will be omitted.

Referring to FIG. 7A, the integrated circuit 70a may include active patterns extending in the X axis direction, and may include gates extending in the Y axis direction. The first memory entity 71 may include the first circuit region CKT1 and the second memory entity 72 may include the second circuit region CKT2. In one or more embodiments, the first circuit region CKT1 may include elements of a peripheral circuit of the first memory entity 71, and the second circuit region CKT2 may include elements of a peripheral circuit of the second memory entity 72. In one or more embodiments, a layout of FIG. 7A and a layout of FIG. 6A may be adjacent in the Y axis direction at a location at which a boundary 73 and the boundary 63 are aligned.

The first memory entity 71 and the second memory entity 72 may share two or more taps. For instance, as illustrated in FIG. 7A, the integrated circuit 70a may include a first tap T71 and a second tap T72 extending in the Y axis direction along the boundary 73, and the first memory entity 71 and the second memory entity 72 may share the first tap T71 and the second tap T72. In one or more embodiments, the first tap T71 may be an n-tap, and the second tap T72 may be a p-tap. As illustrated in FIG. 7A, the first memory entity 71 may include a first dummy gate G71 extending in the Y axis direction between the first tap T71 and the second tap T72 which are shared and the first circuit region CKT1, and the second memory entity 72 may include a second dummy gate G72 extending in the Y axis direction between the first tap T71 and the second tap T72 which are shared and the second circuit region CKT2.

Referring to FIG. 7B, the integrated circuit 70b may include active patterns extending in the X axis direction, and may include gates extending in the Y axis direction. The first memory entity 71 may include the first circuit region CKT1 and the second memory entity 72 may include the second circuit region CKT2. In one or more embodiments, the first circuit region CKT1 may include elements of a peripheral circuit of the first memory entity 71, and the second circuit region CKT2 may include elements of a peripheral circuit of the second memory entity 72. In one or more embodiments, a layout of FIG. 7B and a layout of FIG. 6C may be adjacent in the Y axis direction at a location at which the boundary 73 and the boundary 63 are aligned.

The first memory entity 71 and the second memory entity 72 may share two or more taps. For instance, as illustrated in FIG. 7B, the integrated circuit 70b may include the first tap T71 and the second tap T72 extending in the Y axis direction along the boundary 73, and the first memory entity 71 and the second memory entity 72 may share the first tap T71 and the second tap T72. In one or more embodiments, the first tap T71 may be an n-tap, and the second tap T72 may be a p-tap. As illustrated in FIG. 7A, the first memory entity 71 may include the first dummy gate G71 extending in the Y axis direction between the first tap T71 and the second tap T72 which are shared and the first circuit region CKT1, and the second memory entity 72 may include the second dummy gate G72 extending in the Y axis direction between the first tap T71 and the second tap T72 which are shared and the second circuit area CKT2. Compared to the integrated circuit 70a of FIG. 7A, in FIG. 7B, the first tap T71 and the second tap T72 may have an expanded width (in other words, a length in the X-axis direction).

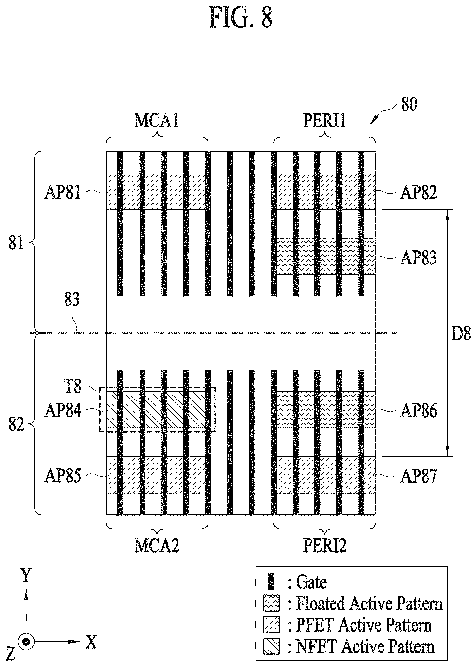

FIG. 8 is a drawing illustrating a layout of an integrated circuit 80 according to one or more embodiments. For instance, FIG. 8 illustrates a layout of the integrated circuit 80 including a first memory entity 81 and a second memory entity 82 which are adjacent to each other in the Y axis direction. For the sake of convenience in illustration, FIG. 8 illustrates only a partial area of the first memory entity 81 and the second memory entity 82 around a boundary 83 between the first memory entity 81 and the second memory entity 82.

Referring to FIG. 8, the first memory entity 81 may include a first memory cell array area MCA1 and a first peripheral circuit area PERI1, and the second memory entity 82 may include a second memory cell array area MCA2 and a second peripheral circuit area PERI2. Active patterns may extend in the X axis direction in the integrated circuit 80, and gates may extend in the Y axis direction. For instance, as illustrated in FIG. 8, the first memory entity 81 may include a first active pattern AP81 extending in the X axis direction in a first memory cell area MCA1, and may include a second active pattern AP82 and a third active pattern AP83 extending in the X axis direction in the first peripheral circuit area PERI1. Further, the second memory entity 82 may include a fourth active pattern AP84 and a fifth active pattern AP85 extending in the X axis direction in the second memory cell array area MCA2, and may include a sixth active pattern AP86 and a seventh active pattern AP87 extending in the X axis direction in the second peripheral circuit area PERI2. As illustrated in FIG. 8, the second memory entity 82 may include a tap T8, and, in one or more embodiments, the tap T8 may be an n-tap.

In one or more embodiments, a memory entity may include a termination structure, and may include an active pattern which is electrically floating, such that the electrically floating active pattern may not be electrically connected to a circuit node, such as the supply voltage or ground. For instance, as illustrated in FIG. 8, the third active pattern AP83 extending in the X axis direction in the first peripheral circuit area PERI1 of the first memory entity 81 may be a floating active pattern, and the sixth active pattern AP86 extending in the X axis direction at the second peripheral circuit area PERI2 of the second memory entity 82 may also be a floating active pattern. Due to termination structures including the third active pattern AP83 and the sixth active pattern AP86, the second active pattern AP82 forming transistors of the first peripheral circuit area PERI1 and the seventh active pattern AP87 forming transistors of the second peripheral circuit area PERI2 may be spaced apart by a distance D8, and an area for termination structures may be required.

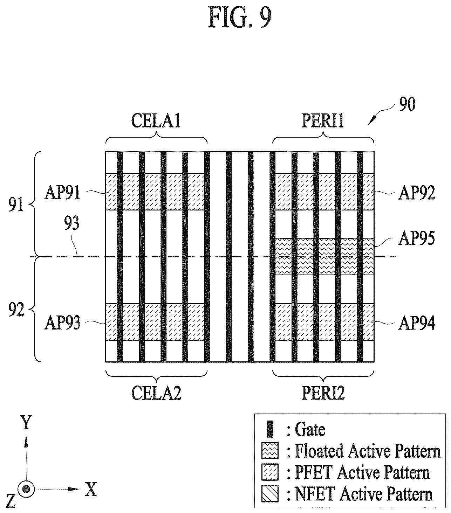

FIG. 9 is a drawing illustrating examples of a layout of an integrated circuit according to one or more embodiments. For instance, FIG. 9 illustrates a layout of an integrated circuit 90 including a first memory entity 91 and a second memory entity 92 which are adjacent to each other in the Y axis direction. For the sake of convenience in illustration, FIG. 9 illustrates only a partial area of the first memory entity 91 and the second memory entity 92 around the boundary 53 between the first memory entity 51 and the second memory entity 52. Duplicate descriptions in what is described above with reference to the drawings among descriptions with respect to FIG. 9 will be omitted.

Referring to FIG. 9, the integrated circuit 90 may include active patterns extending in the X axis direction, and may include gates extending in the Y axis direction. For instance, the first memory entity 91 may include a first active pattern AP91 extending in the X axis direction in a first memory cell array area CELA1, and may include a second active pattern AP92 extending in the X axis direction in the first peripheral circuit area PERI1. Further, the second memory entity 92 may include a third active pattern AP93 extending in the X axis direction in a second memory cell array area CELA2, and may include a fourth active pattern AP94 extending in the X axis direction in the second peripheral circuit area PERI2.

The first memory entity 91 and the second memory entity 92 which are adjacent to each other in the Y axis direction may share termination structures. For instance, as illustrated in FIG. 9, the integrated circuit 90 may include a fifth active pattern AP95 extending in the X axis direction along a boundary 93, and the fifth active pattern AP95 which is electrically floating may be shared by the first memory entity 91 and the second memory entity 92. In one or more embodiments, the first memory entity 91 and the second memory entity 92 which are adjacent to each other in the Y axis direction may share a tap. Compared to the integrated circuit 80 of FIG. 8, in the integrated circuit 90 of FIG. 9, the second active pattern AP92 and the fourth active pattern AP94 may be closer than the distance D8 of FIG. 8, and accordingly, at the integrated circuit 90, an area including the first memory entity 91 and the second memory entity 92 may have a decreased area. In one or more embodiments, each of the first active pattern AP91 to the fourth active pattern AP94 may include at least one fin extending in the X axis direction. A pitch of closest pins between the first active pattern AP91 and the third active pattern AP93 may be a multiple of a pitch of pins in the integrated circuit 90. At least one of the gates in the first peripheral circuit area PERI1 may be apart from the fifth active pattern AP95 in the Y axis direction and configured to form at least one transistor included in the first peripheral circuit area PERI1. At least one of the gates in the second peripheral circuit area PERI2 may be apart from the fifth active pattern AP95 in the Y axis direction and configured to form at least one transistor included in the second peripheral circuit area PERI2.

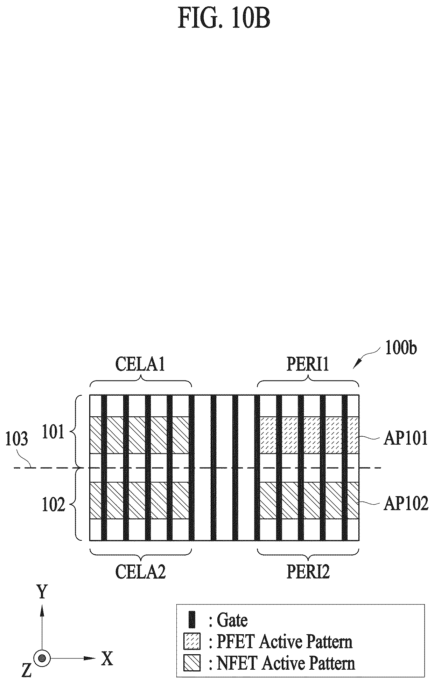

FIG. 10A and FIG. 10B are drawings illustrating examples of a layout of an integrated circuit according to example embodiments. For instance, FIG. 10A and FIG. 10B indicate layouts of integrated circuits 100a and 100b each including a first memory entity 101 and a second memory entity 102 which are adjacent to each other in the Y axis direction. For the sake of convenience in illustration, FIG. 10A and FIG. 10B illustrate only a partial area of the first memory entity 101 and the second memory entity 102 around a boundary 103 between the first memory entity 101 and the second memory entity 102. Duplicate descriptions in descriptions with respect to FIG. 10A and FIG. 10B and duplicate descriptions in what is described above with reference to the drawings will be omitted.

In FIG. 10A, layers of the integrated circuit 100a will be illustrated by being separated. A bottom drawing of FIG. 10A illustrates the substrate SUB and an n-well at the integrated circuit 100a, and a central drawing of FIG. 10A illustrates active patterns and gates in the integrated circuit 100a, and a top drawing of FIG. 10A illustrates the first routing layer M1 and the second routing layer M2 in the integrated circuit 100a.

Referring to the bottom drawing of FIG. 10A, the first memory entity 101 and the second memory entity 102 may share a well W10 extending in the X axis direction along the boundary 103 on the substrate SUB.

Referring to the central drawing of FIG. 10A, the integrated circuit 100a may include active patterns extending in the X axis direction, and may include gates extending in the Y axis direction. The first memory entity 101 may include a first active pattern AP101 extending in the X axis direction in the first peripheral circuit area PERI1, and the second memory entity 102 may include a second active pattern AP102 extending in the X axis direction in the second peripheral circuit area PERI2. Further, as illustrated in FIG. 10A, the first memory entity 101 may include a first tap T101 extending in the X axis direction, and the second memory entity 102 may include a second tap T102 extending in the X axis direction. In one or more embodiments, the first tap T101 and the second tap T102 may be an n-tap. In one or more embodiments, the first tap T101 and the second tap T102 may be omitted. Compared to the integrated circuit 90 of FIG. 9, an active pattern which is floating in the integrated circuit 100a may be omitted, and, accordingly, the first active pattern AP101 forming transistors included in the first peripheral circuit area PERI1 and the second active pattern AP102 forming transistors included in the second peripheral circuit area PERI2 may be closer than the second active pattern AP92 and the fourth active pattern AP94 of FIG. 9.

Referring to a top drawing of FIG. 10A, the first memory entity 101 and the second memory entity 102 may share a pattern (e.g., the first pattern M11) of the first routing layer M1 extending in the X axis direction along the boundary 103. In one or more embodiments, a positive supply voltage may be applied to the pattern (e.g., the first pattern M11) of the first routing layer M1, and transistors formed by the first active pattern AP101 and the second active pattern AP102 may receive a positive supply voltage from the first routing layer M1.

The first memory entity 101 and the second memory entity 102 may include patterns extending in the Y axis direction in the second routing layer M2. For instance, as illustrated in FIG. 10A, the first memory entity 101 may include a first pattern M21 to a third pattern M23 which extend in the Y axis direction at the second routing layer M2, and the second memory entity 102 may include a fourth pattern M24 to a sixth pattern M26 which extend in the Y axis direction in the second routing layer M2. In one or more embodiments, patterns of the second routing layer M2 extending in the Y axis direction at a memory cell array area may correspond to word lines.

Referring to FIG. 10B, the integrated circuit 100b may include active patterns extending in the X axis direction, and may include gates extending in the Y axis direction. The first memory entity 101 may include the first active pattern AP101 extending in the X axis direction in the first peripheral circuit area PERI1, and the second memory entity 102 may include the second active pattern AP102 extending in the X axis direction in the second peripheral circuit area PERI2.

The first active pattern AP101 and the second active pattern AP102 which are adjacent to each other with the boundary 103 placed therebetween in the integrated circuit 100a of FIG. 10A may have an identical conductivity type, and may form PFETs, whereas the first active pattern AP101 and the second active pattern AP102 which are adjacent to each other with the boundary 103 placed therebetween in the integrated circuit 100b of FIG. 10B may respectively have conductivity types different from each other, and may respectively form PFETs and NFETs. Accordingly, in the integrated circuit 100b of FIG. 10B, a pattern of a routing layer providing a supply voltage in common to transistors formed by the first active pattern AP101 and the second active pattern AP102 may be omitted.

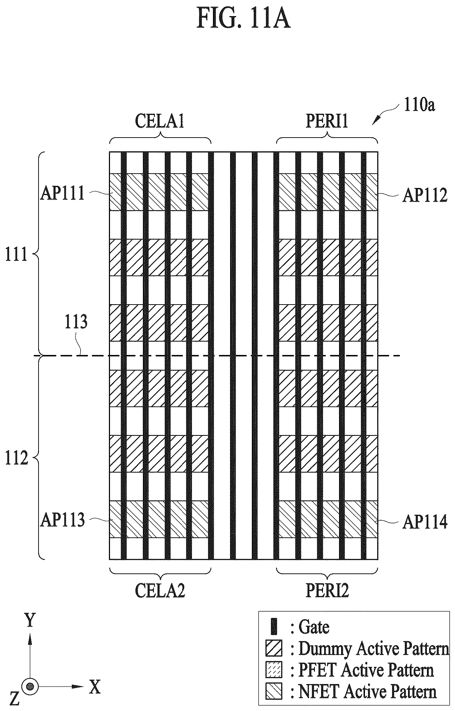

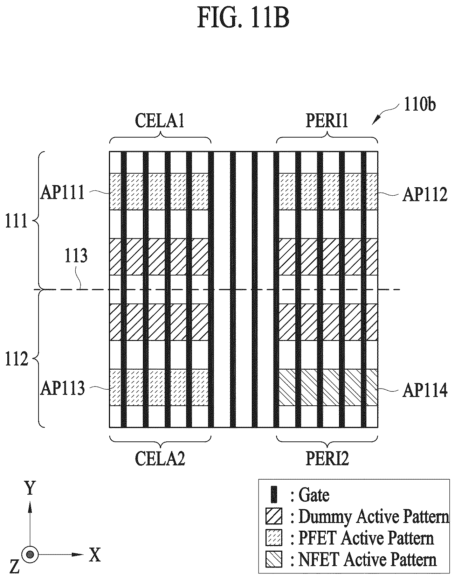

FIG. 11A and FIG. 11B are drawings illustrating examples of a layout of an integrated circuit according to example embodiments. For instance, FIG. 11A and FIG. 11B indicate layouts of integrated circuits 110a and 110b each including a first memory entity 111 and a second memory entity 112 which are adjacent to each other in the Y axis direction. For the sake of convenience in illustration, FIG. 11A and FIG. 11B illustrate only a partial area of the first memory entity 111 and the second memory entity 112 around a boundary 113 between the first memory entity 111 and the second memory entity 112. Duplicate descriptions in descriptions to FIG. 11A and FIG. 11B and duplicate descriptions to what is described above with reference to the drawings will be omitted.

Referring to FIG. 11A and FIG. 11B, each of the integrated circuit 110a and the integrated circuit 110b may include active patterns extending in the X axis direction, and may include gates extending in the Y axis direction. The first memory entity 111 may include a first active pattern AP111 extending in the X axis direction in the first memory cell array area CELA1, and may include a second active pattern AP112 extending in the X axis direction in the first peripheral circuit area PERI1. Further, the second memory entity 112 may include a third active pattern AP113 extending in the X axis direction in the second memory cell array area CELA2, and a fourth active pattern AP114 extending in the X axis direction in the second peripheral circuit area PERI2.

In one or more embodiments, a memory entity may include at least one dummy active pattern adjacent to a boundary. For instance, as illustrated in FIG. 11A, the first memory entity 111 may include two dummy active patterns extending in the X axis direction in a first cell array area CELA1, and may include two dummy active patterns extending in the X axis direction in the first peripheral circuit area PERI1. Further, the second memory entity 112 may include two dummy active patterns extending in the X axis direction in the second memory cell array area CELA2, and may include two dummy active patterns extending in the X axis direction in the second peripheral circuit area PERI2. Further, as illustrated in FIG. 11B, the first memory entity 111 may include one dummy active pattern extending in the X axis direction in the first cell array area CELA1, and may include one dummy active pattern extending in the X axis direction in the first peripheral circuit area PERI1. Further, the second memory entity 112 may include one dummy active pattern extending in the X axis direction in the second memory cell array area CELA2, and may include one dummy active pattern extending in the X axis direction in the second peripheral circuit area PERI2. In some embodiments, a dummy active pattern may be electrically floating.

In FIG. 11A and FIG. 11B, dummy active patterns may have a pitch identical to a pitch of NFET active patterns and PFET active patterns. For instance, in the integrated circuit 110a and the integrated circuit 110b, a pair of an NFET active pattern and a PFET active pattern which are adjacent to each other may have a predetermined pitch, and, a pair of dummy patterns corresponding to the pair of the NFET active pattern and the PFET active pattern may also have an identical pitch.

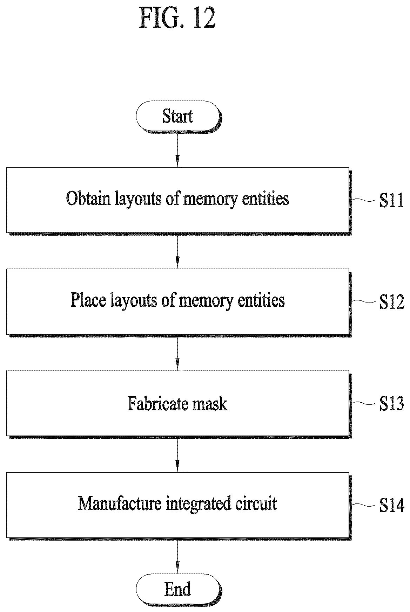

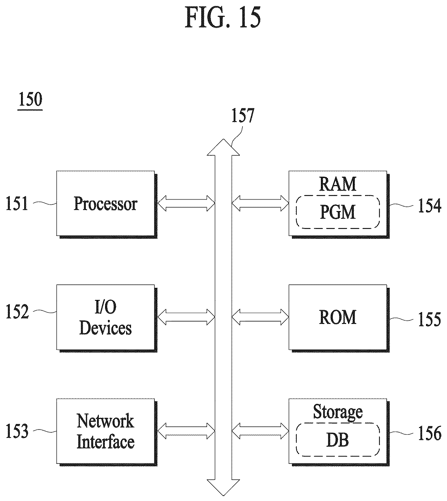

FIG. 12 is a flowchart illustrating a method of manufacturing an integrated circuit according to one or more embodiments. Specifically, the flowchart of FIG. 12 illustrates an example of a method for manufacturing an integrated circuit including a plurality of memory entities. As illustrated in FIG. 12, the method for manufacturing the integrated circuit may include a plurality of operations (e.g., S11 to S14). In one or more embodiments, operation S11 and operation S12 may be performed by a computing system (for instance, a computing system 150 in FIG. 15), and may be generally referred to as a method for designing an integrated circuit.

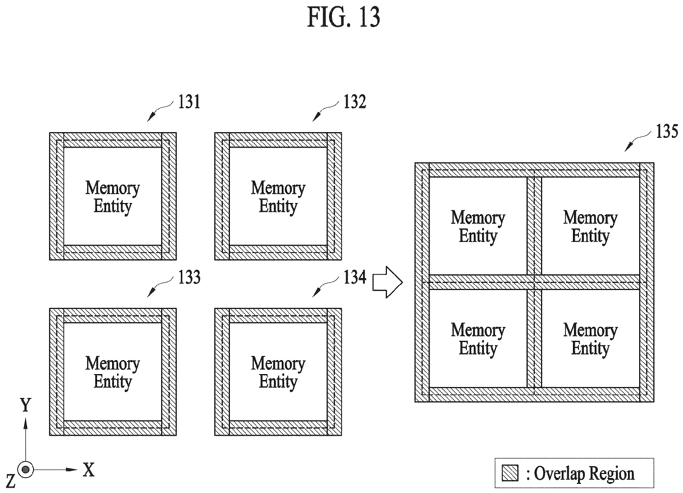

Referring to FIG. 12, in operation S11, layouts of memory entities may be obtained. As described above with reference to FIG. 1A and FIG. 1B, a memory entity may be designed to be independent to another memory entity, and layouts of memory entities which are designed to be independent to each other may be obtained. A layout of a memory entity may be defined by layout data, and layout data may be collected. Layout data may have a format such as GDSII, for instance, and may include geometrical information of a layout. As described below with reference to FIG. 13, a layout of a memory entity may include an overlapping area shared with a memory entity adjacent to a boundary.

In operation S12, layouts of memory entities may be placed. For instance, each of layouts of memory entities obtained in operation S11 may be placed to be adjacent to a layout of at least one other memory entity. Accordingly, memory entities which are placed to be adjacent may share an overlapping area. Layout data in which layouts of memory entities are placed, in other words, layout data defining a layout of an integrated circuit, may be generated.

In operation S13, a mask may be fabricated. For instance, optical proximity correction (OPC) for correcting distortion such as refraction caused by characteristics of light in photolithography may be applied to layout data. In order to form patterns disposed at a plurality of layers based on data to which the OPC is applied, patterns on a mask may be defined, and at least one mask (or, a photomask) for forming each pattern of a plurality of layers may be fabricated. In one or more embodiments, a layout of an integrated circuit may be limitedly deformed in operation S13, and limited deformation of a layout of an integrated circuit in operation S13 is a post-processing for optimizing a structure of an integrated circuit, and may be referred to as design polishing.

In operation S14, an integrated circuit may be manufactured. For instance, with a plurality of layers being patterned by using at least one mask fabricated in operation S13, an integrated circuit IC may be manufactured. A front-end-of-line (FEOL) may include, for instance, planarizing and cleaning a wafer, forming a trench, forming a well, forming a gate electrode, and forming a source and a drain. By the FEOL, individual elements, such as a transistor, a capacitor, a resistance and the like may be formed on a substrate. Further, a back-end-of-line (BEOL) may include, for instance, silicidating a gate, source and drain area, adding a dielectric, flattening, forming a hole, adding a metal layer, forming a via, forming a passivation layer and the like. By the BEOL, individual elements, such as a transistor, a capacitor, a resistance and the like may be connected to each other. In one or more embodiments, a middle-of-line (MOL) may be performed between the FEOL and the BEOL, and contacts may be formed on individual elements. After then, an integrated circuit may be packaged in a semiconductor package, and may be used as a component of various applications.

FIG. 13 is a drawing illustrating a method of designing an integrated circuit according to one or more embodiments. For instance, FIG. 13 indicates layouts of the first memory entity 131 to a fourth memory entity 134 and a layout of an integrated circuit 135 in which the layouts of the first memory entity 131 to the fourth memory entity 134 are placed. Hereinafter, FIG. 13 will be described with reference to FIG. 12.

Referring to FIG. 13, each of layouts of a first memory entity 131 to a fourth memory entity 134 may include an overlapping area at a boundary. As described above with reference to the drawings, memory entities adjacent to each other may share a termination structure, and a termination structure may be removed from memory entities adjacent to each other. For a termination structure which is shared or omitted, a layout of a memory entity may include an overlapping area extending along a boundary. Accordingly, an area of a layout of a memory entity defined by a boundary may be smaller than an area including an overlapping area.

A memory entity including an overlapping area at a boundary may be placed in order to be mutually adjacent to another memory entity, in other words, in order for boundaries to overlap each other. For instance, as illustrated in FIG. 13, the first memory entity 131 to the fourth memory entity 134 may be placed in order for boundaries to overlap each other, and, accordingly, overlapping areas may overlap each other. As a result, an area including the first memory entity 131 to the fourth memory entity 134 in an integrated circuit 135 may have a decreased area due to mutually overlapping areas.

FIG. 14 is a block diagram illustrating an SoC 140 according to one or more embodiments. The SoC 140 may refer to an integrated circuit integrating components of a computing system or other electronic systems. For instance, as an example of the SoC 140, an application processor (AP) may include components for a processor and other functions. As illustrated in FIG. 14, the SoC 140 may include a core 141, a neural processing unit (NPU) 142, a GPU 143, a built-in memory 144, a communication interface 145 and a memory interface 146. Components of the SoC 140 may communicate with each other through a bus 147. The components of the SoC 140 may include memory entities, and, as described above with reference to the drawings, the memory entities may be placed to be adjacent to each other, and may have a decreased area.

The core 141 may process instructions, and may control an operation of the components included in the SoC 140. For instance, the core 141 may, by processing a series of instructions, operate an operating system, and may execute applications on the operating system. The NPU 142 may perform calculations for an artificial neural network. The GPU 143 may generate data for an image outputted through a display device from image data provided from the built-in memory 144 or the memory interface 146, and may encode the image data. In one or more embodiments, the NPU 142 and/or the GPU 143 may include integrated circuits described above with reference to the drawings, and, accordingly, may have improved performance, efficiency and expandability. The built-in memory 144 may store data required for the core 141, the NPU 142 and the GPU 143 to operate. The communication interface 145 may provide an interface for one-to-one communication or a communication network. The memory interface 146 may provide an interface with respect to an external memory of the SoC 140, for instance, a dynamic random access memory (DRAM), a flash memory and the like.

FIG. 15 is a block diagram illustrating the computing system 150 including a memory storing a program according to one or more embodiments. At least a part of a method for designing an integrated circuit according to example embodiments, for instance, operations in FIG. 12, may be performed in the computing system (or a computer) 150.

The computing system 150 may be a fixed type computing system such as a desktop computer, a work station, a server and the like, and may be a portable computing system such as a laptop computer and the like. As illustrated in FIG. 15, the computing system 150 may include a processor 151, input and output (I/O) devices 152, a network interface 153, a random access memory (RAM) 154, a read-only memory (ROM) 155 and a storage 156. The processor 151, the input and output devices 152, the network interface 153, the RAM 154, the ROM 155 and the storage 156 may be connected to a bus 157, and may communicate with each other through the bus 157.

The processor 151 may be referred to as a processing unit, and may include at least one core which may execute an arbitrary instruction set (for instance, Intel Architecture-32 (IA-32), 64 bit extension IA-32, x86-64, PowerPC, Sparc, MIPS, ARM, IA-64 and the like) such as, for instance, a micro-processor, an AP, a digital signal processor (DSP), a GPU and the like. For instance, the processor 151 may access a memory, in other words, the RAM 154 or the ROM 155 through the bus 157, and may execute instructions stored in the RAM 154 or the ROM 155.

The RAM 154 may store a program PGM for a method for designing an integrated circuit or at least a part thereof according to one or more embodiments, and the program PGM may cause the processor 151 to perform at least a part of the method for designing the integrated circuit, for instance, operations included in the method of FIG. 12. In other words, the program PGM may include a plurality of instructions executable by the processor 151, and a plurality of instructions included in the program PGM may cause the processor 151 to perform at least a part of operations included in the method of FIG. 12, for instance.

The storage 156 may not lose stored data even when power supplied to the computing system 150 is blocked. For instance, the storage 156 may include a non-volatile memory device, and may include a storage medium such as a magnetic tape, an optical disk, a magnetic disk and the like. Further, the storage 156 is detachable from the computing system 150. The storage 156 may store the program PGM according to one or more embodiments, and, before the program PGM is executed by the processor 151, the program PGM or at least a part thereof may be loaded from the storage 156 to the RAM 154. Alternatively, the storage 156 may store a file written in a program language, and the program PGM generated by a compiler and the like or at least a part thereof may be loaded from the file to the RAM 154. Further, as illustrated in FIG. 15, the storage 156 may store a database DB, and the database DB may include information required for designing an integrated circuit, for instance, a design rule and the like.

The storage 156 may store data to be processed by the processor 151 or data processed by the processor 151. In other words, the processor 151 may generate data by processing data stored in the storage 156 according to the program PGM, and may store the generated data in the storage 156. For instance, the storage 156 may store layout data defining layouts of memory entities, layout data defining a layout of an integrated circuit and the like.

The input and output devices 152 may include an input device such as a keyboard, a pointing device and the like, and may include an output device such as a display device, a printer and the like. For instance, a user may, through the input and output devices 152, trigger execution of the program PGM by the processor 151, input layout data, and identify the layout data.

The network interface 153 may provide access to a network on the outside of the computing system 150. For instance, a network may include a plurality of computing systems and communication links, and the communication links may include wired links, optical links, wireless links or links of an arbitrary other form.

## Claims

1. An integrated circuit comprising:
a plurality of memory entities (51, 52; 71, 72), each of the plurality of memory entities (51, 52; 71, 72) comprising a memory cell array (21) and a peripheral circuit,
wherein the plurality of memory entities (51, 52; 71, 72) comprises:
a first memory entity (51; 71) comprising first active patterns extending in a first direction (X) and first gate electrodes extending in a second direction (Y) intersecting the first direction (X); and
a second memory entity (52; 72) adjacent to the first memory entity (51; 71) in the first direction (X) and comprising second active patterns extending in the first direction (X) and second gate electrodes extending in the second direction (Y),
wherein a first tap structure (T53; T71) extending in the second direction (Y) along a boundary (53; 73) between the first memory entity (51; 71) and the second memory entity (52; 72) is shared by the first memory entity (51; 71) and the second memory entity (52; 72), and configured to bias a well (W3) or a substrate (SUB).

2. The integrated circuit of claim 1, wherein the first memory entity (51) further comprises a second tap structure (T51) extending in the second direction (Y) and adjacent to the first tap structure (T53), and
wherein the second memory entity (51) further comprises a third tap structure (T52) extending in the second direction (Y) and adjacent to the first tap structure (T53).

3. The integrated circuit of claim 2, wherein the first tap structure (T53) is configured to bias the well (W3), and the well (W3) is in the substrate (SUB) and extends in the second direction (Y) along the boundary (53), and
wherein the second tap structure (T51) and the third tap structure (T52) are configured to bias the substrate (SUB).

4. The integrated circuit of claim 2 or 3, wherein the first active patterns are not between the first tap structure (T53) and the second tap structure (T51), and
wherein the second active patterns are not between the first tap structure (T53) and the third tap structure (T52).

5. The integrated circuit of any one of claims 1 to 4, wherein the first tap structure (T53) comprises a third gate electrode extending in the second direction (Y) along the boundary (53).

6. The integrated circuit of claim 5, wherein the first tap structure further comprises at least one further gate electrode extending in the second direction (Y).

7. The integrated circuit of any one of claims 1 to 6, wherein the first memory entity (51) further comprises a first pattern (M14) extending in the first direction (X) in a first routing layer (M1) of the integrated circuit and configured to have a supply voltage applied thereto, and
wherein the second memory entity (52) further comprises a second pattern (M18) extending in the first direction (X) in the first routing layer (M1) and configured to have the supply voltage applied thereto, and
wherein the first pattern (M14) and the second pattern (M18) are connected to each other at the boundary( 53).

8. An integrated circuit comprising:
a plurality of memory entities (91, 92), each of the plurality of memory entities comprising a memory cell array and a peripheral circuit,
wherein the plurality of memory entities (91, 92) comprises:
a first memory entity (91) comprising first active patterns (AP91, AP92) extending in a first direction (X) and first gate electrodes extending in a second direction (Y) intersecting with the first direction (X); and
a second memory entity (92) adjacent the first memory entity (91) in the second direction (Y) and comprising second active patterns (AP93, AP94) extending in the first direction (X) and second gate electrodes extending in the second direction (Y),
wherein an electrically floating active pattern (AP95) extends in the first direction (X) along a first boundary (93) between the first memory entity (91) and the second memory entity (92), and is shared by the first memory entity (91) and the second memory entity (92).

9. The integrated circuit of claim 8, wherein the first gate electrodes comprise at least one first gate electrode apart from the electrically floating active pattern (AP95) in the second direction (Y) and configured to form at least one transistor included in a first peripheral circuit (PERI1) of the first memory entity (91), and
wherein the second gate electrodes comprise at least one second gate electrode apart from the electrically floating active pattern (AP95) in the second direction (Y) and configured to form at least one transistor included in a second peripheral circuit (PERI2) of the second memory entity (92).

10. The integrated circuit of claim 8 or 9, wherein a first memory cell array (CELA1) of the first memory entity (91) and a second memory cell array (CELA2) of the second memory entity (92) are apart from each other in the second direction (Y) at the first boundary (93), and
wherein the electrically floating active pattern (AP95) is not between the first memory cell array (CELA1) and the second memory cell array (CELA2).

11. The integrated circuit of any one of claims 8 to10, wherein the plurality of memory entities further comprise:
a third memory entity comprising third active patterns extending in the first direction and third gate electrodes extending in the second direction; and
a fourth memory entity adjacent to the third memory entity in the second direction and comprising fourth active patterns extending in the first direction and fourth gate electrodes extending in the second direction,
wherein the third active patterns comprise a first outer edge active pattern closest to a second boundary between the third memory entity and the fourth memory entity, and
wherein the fourth active patterns comprise a second outer edge active pattern closest to the second boundary, and
wherein the first outer edge active pattern and the second outer edge active pattern are adjacent to each other.

12. The integrated circuit of claim 11, wherein the first outer edge active pattern and the second outer edge active pattern have a same conductivity type.

13. The integrated circuit of claim 12, wherein a pattern extending in the first direction along the second boundary in a routing layer is shared by the third memory entity and the fourth memory entity, and configured to receive a supply voltage,
wherein transistors formed by the first outer edge active pattern and transistors formed by the second outer edge active pattern are configured to receive the supply voltage.

14. The integrated circuit of claim 12 or 13, wherein a well extending in the first direction along the second boundary is shared by the third memory entity and the fourth memory entity.

15. The integrated circuit of any one of claims 11 to 14, wherein the first outer edge active pattern and the second outer edge active pattern have conductivity types different from each other.
